# EUROPEAN PATENT APPLICATION

(11) **EP 3 806 333 A1**
(43) Date of publication of application: **14.04.2021**
(21) Application number: 20156470.5
(22) Date of filing: 10.02.2020
(51) Int. Cl.: H03K 17/081, H03K 17/0812, H03K 17/16, H03K 17/0412

(54) **GATE-DRIVING CIRCUIT**

(30) Priority: 08.10.2019 US 201962912161 P
(71) Applicant: Delta Electronics, Inc., Taoyuan County 33341 (TW)
(72) Inventor: CHAO, Wei-Hsiang, 33341 Taoyuan City (TW); SHING, Tai-Kang, 33341 Taoyuan City (TW)
(74) Representative: 2K Patentanwälte Blasberg Kewitz & Reichel

(57) **Abstract**

A circuit includes a resistor, a capacitor, a controller, and a voltage clamp unit. The resistor is coupled between a supply voltage and a first node. The capacitor is coupled between the supply voltage and the first node. The controller periodically couples the first node and a reference node to a control node to generate a control signal at the control node, wherein the range of the control signal is from a first voltage of the first node to the low voltage level of the reference node. The voltage clamp unit, which is coupled between the control node and the reference node, determines the first voltage.

## Description

### BACKGROUND OF THE INVENTION

### Field of the Invention

The disclosure relates generally to a gate-driving circuit for driving the gate terminal of a switching device.

### Description of the Related Art

A GaN device has great potential compared to existing Si devices, and therefore, is anticipated for practical use. A standard GaN FET is a normally-on device, and therefore, needs a negative power source. On the other hand, a normally-off GaN FET is very difficult to produce. The normally-off GaN FET has a threshold voltage of about +1 V, which is very low compared to that of an existing Si MOSFET. This is the first problem with the normally-off GaN FET.

In addition, the normally-off GaN FET can break easily if a large voltage is applied to its gate, such that the normally-off GaN FET is unsuitable for application in a normal driving IC. This is the second problem with the normally-off GaN FET. Due to these two problems, a gate-driving circuit for the Si MOSFET (IGBT, or Insulated Gate Bipolar Transistor) is not applicable for the normally-off GaN FET. Namely, the normally-off GaN FET needs an exclusive gate-driving circuit.

Therefore, a waveform conversion circuit is urgently needed in order to convert the gate drive voltage used for the Si MOSFET to one for the normally-off GaN FET without reducing the switching speed, and this waveform conversion can be adopted for use

### BRIEF SUMMARY OF THE INVENTION

In an embodiment, a circuit comprises a resistor, a capacitor, a controller, and a voltage clamp unit. The resistor is coupled between a supply voltage and a first node. The capacitor is coupled between the supply voltage and the first node. The controller periodically couples the first node and a reference node to a control node to generate a control signal at the control node, wherein the range of the control signal is from a first voltage of the first node to the low voltage level of the reference node. The voltage clamp unit is coupled between the control node and the reference node and determining the first voltage.

According to an embodiment of the invention, the first voltage is not greater than the supply voltage.

According to an embodiment of the invention, the controller comprises a first switch and a second switch. The first switch couples the first node to the control node. The second switch couples the reference node to the control node. The first switch and the second switch are alternately turned on and off.

According to an embodiment of the invention, the resistor and the capacitor are configured to determine an overshoot voltage for the control signal in response to the first switch being on, wherein the overshoot voltage is configured to turn on the switch device at high speed.

According to an embodiment of the invention, when the first switch is turned on, the supply voltage charges a parasitic capacitor at the control node, wherein once the control signal reaches the first voltage, the supply voltage provides a fixed current flowing through the resistor to the voltage clamp unit so that the voltage clamp unit clamps the control signal at a turn-on voltage of the voltage clamp unit.

According to an embodiment of the invention, once the first switch is turned off and the second switch is turned on, the supply voltage charges the first node through the resistor, and the control signal is in the low voltage level.

According to an embodiment of the invention, the circuit further comprises a switch device. The switch device comprises a gate terminal, a drain terminal, and a source terminal, in which the gate terminal is coupled to the control node, the drain terminal sinks a power current, and the source terminal is coupled to the reference node.

According to an embodiment of the invention, the voltage clamp unit comprises a zener diode. The zener diode comprises an anode and a cathode, in which the anode is coupled to the source terminal of the switch device, and the cathode is coupled to the gate terminal of the switch device. The first voltage is determined by a reverse breakdown voltage of the zener diode.

In an embodiment, a gate-driving circuit for turning on and off a switch device having a gate terminal coupled to a control node, a drain terminal sinking a power current, and a source terminal coupled to a reference node is provided. The gate-driving circuit comprises a resistor, a capacitor, a controller, and a voltage clamp unit. The resistor is coupled between a supply voltage and a first node. The capacitor is coupled between the supply voltage and the first node. The controller periodically couples the first node and the reference node to the control node to generate a control signal at the control node, wherein the range of the control signal is from the a first voltage of the first node to the low voltage level of the reference node. The voltage clamp unit is coupled between the control node and the reference node and determining the first voltage.

According to an embodiment of the invention, the first voltage is not greater than the supply voltage.

According to an embodiment of the invention, the controller comprises a first switch and a second switch. The first switch couples the first node to the control node. The second switch couples the reference node to the control node. The first switch and the second switch are alternately turned on and off.

According to an embodiment of the invention, the resistor and the capacitor are configured to determine an overshoot voltage for the control signal in response to the first switch being on, wherein the overshoot voltage is configured to turn on the switch device at high speed.

According to an embodiment of the invention, when the first switch is turned on, the supply voltage charges a parasitic capacitor at the control node, wherein once the control signal reaches the first voltage, the supply voltage provides a fixed current flowing through the resistor to the voltage clamp unit so that the voltage clamp unit clamps the control signal at a turn-on voltage of the voltage clamp unit.

According to an embodiment of the invention, once the first switch is turned off and the second switch is turned on, the supply voltage charges the first node through the resistor, and the control signal is in the low voltage level.

According to an embodiment of the invention, the controller, the voltage clamp unit, and the switch device are packaged together.

According to an embodiment of the invention, the voltage clamp unit comprises a zener diode. The zener diode comprises an anode and a cathode, in which the anode is coupled to the source terminal of the switch device, and the cathode is coupled to the gate terminal of the switch device. The first voltage is determined by a reverse breakdown voltage of the zener diode.

According to another embodiment of the invention, the voltage clamp unit comprises a zener diode. The zener diode comprises an anode and a cathode, in which the anode is coupled to the gate terminal of the switch device, and the cathode is coupled to the source terminal of the switch device. The first voltage is determined by a forward voltage of the zener diode.

According to another embodiment of the invention, the voltage clamp unit comprises a diode. The diode comprises an anode and a cathode, in which the anode is coupled to the gate terminal of the switch device, and the cathode is coupled to the source terminal of the switch device. The first voltage is determined by a forward voltage of the diode.

According to another embodiment of the invention, the voltage clamp unit comprises a first zener diode and a second zener diode. The first zener diode comprises a first anode and a first cathode, in which the first anode is coupled to a first node, and the first cathode is coupled to the gate terminal of the switch device. The second zener diode comprises a second anode and a second cathode, in which the second anode is coupled to the first anode, and the second cathode is coupled to the source terminal of the switch device. The first voltage is determined by a sum of the reverse breakdown voltage of the second zener diode and a forward voltage of the first zener diode.

According to another embodiment of the invention, the voltage clamp unit comprises a first diode and a zener diode. The first diode comprises a first anode and a first cathode, in which the first anode is coupled to the gate terminal of the switch device. The zener diode comprises a zener anode and a zener cathode, in which the zener cathode is coupled to the source terminal of the switch device, and the zener anode is coupled to the first cathode. The first voltage is determined by a sum of a reverse breakdown voltage of the zener diode and a forward voltage of the diode.

According to another embodiment of the invention, the voltage clamp unit comprises a zener diode and a first diode. The zener diode comprises a zener anode and a zener cathode, in which the zener cathode is coupled to the gate terminal of the switch device. The first diode comprises a first anode and a first cathode, in which the first anode is coupled to the source terminal of the switch device, and the first cathode is coupled to the zener anode. The first voltage is the supply voltage.

A detailed description is given in the following embodiments with reference to the accompanying drawings.

### BRIEF DESCRIPTION OF DRAWINGS

The invention can be more fully understood by reading the subsequent detailed description and examples with references made to the accompanying drawings, wherein:
Fig. 1 is a schematic diagram of a gate-driving circuit in accordance with an embodiment of the invention;
Fig. 2 illustrates waveforms of the gate-driving circuit in Fig. 1 in accordance with an embodiment of the invention;
Fig. 3 is a schematic diagram of a gate-driving circuit in accordance with another embodiment of the invention;
Fig. 4 is a schematic diagram of a gate-driving circuit in accordance with another embodiment of the invention;
Fig. 5 is a schematic diagram of a gate-driving circuit in accordance with another embodiment of the invention;
Fig. 6 is a schematic diagram of a gate-driving circuit in accordance with another embodiment of the invention;
Fig. 7 is a schematic diagram of a gate-driving circuit in accordance with another embodiment of the invention; and
Fig. 8 is a schematic diagram of a gate-driving circuit in accordance with another embodiment of the invention.

### DETAILED DESCRIPTION OF THE INVENTION

This description is made for the purpose of illustrating the general principles of the invention and should not be taken in a limiting sense. In addition, the present disclosure may repeat reference numerals and/or letters in the various examples. This repetition is for the purpose of simplicity and clarity and does not in itself dictate a relationship between the various embodiments and/or configurations discussed. The scope of the invention is best determined by reference to the appended claims.

It is understood that the following disclosure provides many different embodiments, or examples, for implementing different features of the application. Specific examples of components and arrangements are described below to simplify the present disclosure. These are, of course, merely examples and are not intended to be limiting. In addition, the present disclosure may repeat reference numerals and/or letters in the various examples. This repetition is for the purpose of simplicity and clarity and does not in itself dictate a relationship between the various embodiments and/or configurations discussed. Moreover, the formation of a feature on, connected to, and/or coupled to another feature in the present disclosure that follows may include embodiments in which the features are formed in direct contact, and may also include embodiments in which additional features may be formed interposing the features, such that the features may not be in direct contact.

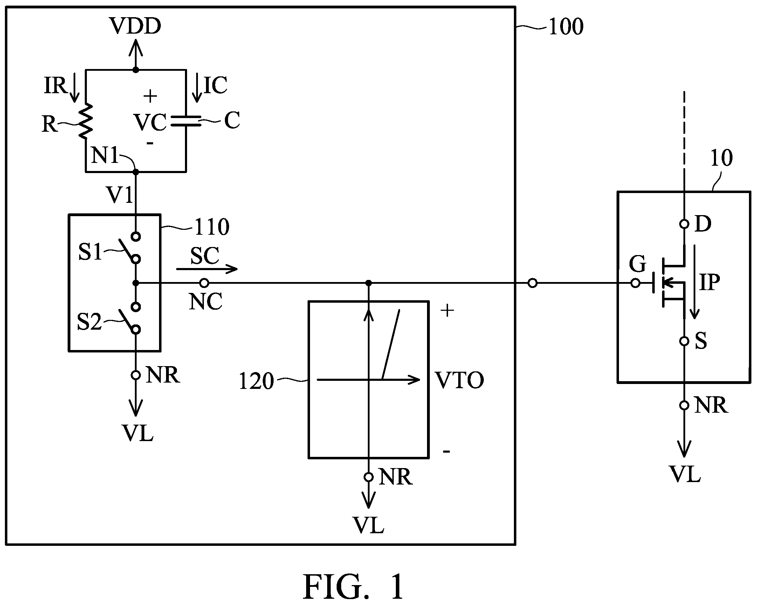

Fig. 1 is a schematic diagram of a gate-driving circuit in accordance with an embodiment of the invention. As shown in Fig. 1, the gate-driving circuit 100 is configured to turn ON/OFF the switch device 10 to sink a power current. The switch device 10 includes the gate terminal G, the source terminal S, and the drain terminal D. According to an embodiment of the invention, the switch device 10 is a normally-off transistor. According to another embodiment of the invention, the switch device is a normally-off GaN FET.

The gate-driving circuit 100 includes a resistor R, a capacitor C, a controller 110, and a voltage clamp unit 120. The resistor R is coupled between the supply voltage VDD and a first node N1, and the capacitor C is coupled between the supply voltage VDD and the first node N1.

The controller 110, which is coupled between the first node N1 and the reference node NR, includes the first switch S1 and the second switch S2. The first switch S1 and the second switch S2 are alternately turned ON and OFF, to generate ON/OFF pulses on the control signal SC at the control node NC. The controller 110 is simplified as the first switch S1 and the second switch S2 for the simplicity of explanation.

The ON/OFF pulses of the control signal SC are applied to the gate terminal G of the switch device 10 so that the switch device 10 is turned ON and OFF periodically. The control signal SC ranges from a high voltage level to a low voltage level VL of the reference node NR, in which the high voltage level is equal to the first voltage V1 of the first node N1, which will be discussed in the following paragraphs. According to an embodiment of the invention, the high voltage level of the control signal SC exceeds the threshold voltage of the switch device 10 so as to turn ON the switch device 10.

The voltage clamp unit 120, which is coupled between the control node NC and the reference node NR, is configured to clamp the voltage across the gate terminal G and the source terminal S. According to an embodiment of the invention, the supply voltage VDD exceeds the breakdown voltage of the switch device 10. Namely, the voltage clamp unit 120 is configured to protect the switch device 10 from directly biased by the supply voltage VDD.

When an ON pulse of the control signal SC is applied to the gate terminal G of the switch device 10, the first switch S1 of the controller 110 is turned ON so that the high voltage level of the control signal SC is equal to the first voltage V1 of the first node N1. In addition, when the first voltage V1 exceeds a turn-on voltage VTO of the voltage clamp unit 120, the voltage clamp unit 120 is turned ON so that the first voltage V1 is clamped at the turn-on voltage VTO of the voltage clamp unit 120 so as to protect the switch device 10 from breakdown.

When an OFF pulse of the control signal SC is applied to the gate terminal G of the switch device 10, the second switch S2 of the controller 110 is turned ON to pull the control signal SC of the control node NC down to the low voltage level VL. According to an embodiment of the invention, the reference node NR is coupled to the ground, and the low voltage level is the ground level.

According to an embodiment of the invention, the controller 110, the voltage clamp unit 120, and the switch device 10 can be packaged together. According to another embodiment of the invention, the controller 110, the voltage clamp unit 120, and the switch device 10 can be implemented in System-on-Chip (SoC). According to other embodiments of the invention, the controller 110, the voltage clamp unit 120, and the switch device 10 can be integrated together.

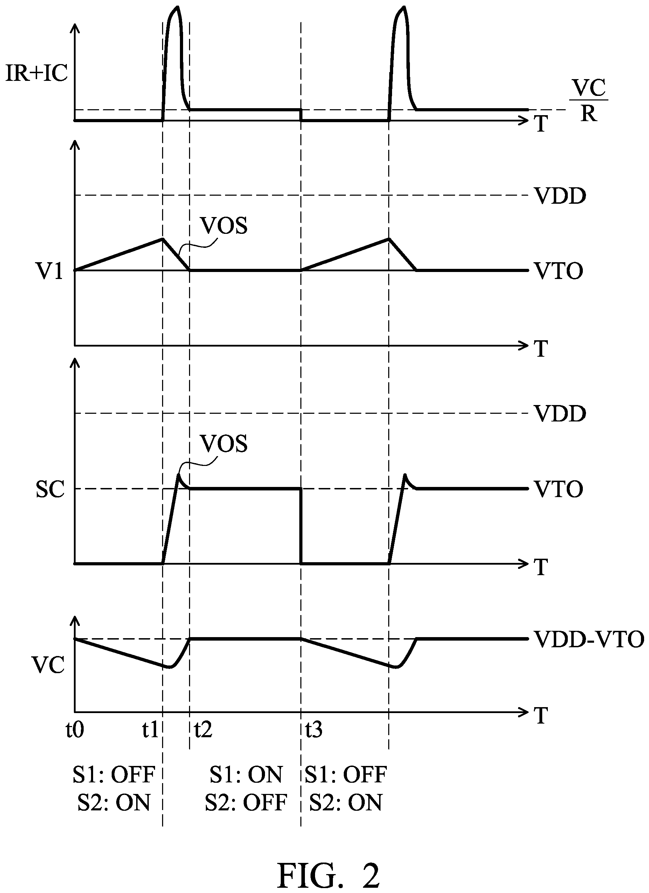

Fig. 2 illustrates waveforms of the gate-driving circuit in Fig. 1 in accordance with an embodiment of the invention. As shown in Fig. 2, a sum of a resistor current IR flowing through the resistor R and a capacitor current IC flowing through the capacitor C, the first voltage V1 at the first node N1, the control signal SC, and a capacitor voltage VC across the capacitor C are illustrated.

During time t0 to time t1, the first switch S1 of the controller 110 is turned OFF and the second switch S2 is turned ON, and the control signal SC at the control node NC is pulled down to the low voltage level VL. According to an embodiment of the invention, the low voltage level VL is the ground level, so that the control signal SC is in the ground level and the voltage across the gate terminal G and the source terminal S of the switch device 10 is zero during time t0 to time t1.

Since the first switch S1 is turned OFF during time t0 to time t1, the voltage V1 at the first node N1 is charged by the supply voltage VDD through the resistor R and the capacitor C, but still less than the supply voltage VDD. Accordingly, during time t0 to time t1, the first voltage V1 rises toward the supply voltage VDD, the sum of the resister current IR and the capacitor current IC is about zero during time t0 to time t1, and the capacitor voltage VC across the capacitor C falls.

At time t1, the first switch S1 is turned ON and the second switch S2 is turned OFF, and the first voltage V1 is provided to the control node NC, so that the first voltage V1 drops dramatically due to charge sharing between the capacitor C and the parasitic capacitance along the first node N1 to the voltage clamp unit 120, and then rises to generate an overshoot voltage VOS. According to an embodiment of the invention, the overshoot voltage VOS is determined by the capacitor C and the parasitic capacitance along the first node N1 to the voltage clamp unit 120.

Accordingly, the sum of the resistor current IR and the capacitor current IC rises dramatically and then goes back to the capacitor voltage VC over the resistor R, which is VC/R. Since the first node N1 is coupled to the control node NC when the first switch S1 is turned ON, the control signal SC rises along with the first voltage VI, and the overshoot voltage VOS is also generated at the control signal SC. According to an embodiment of the invention, the overshoot voltage VOS may assist to rapidly turn ON the switch device 10. Since the capacitor voltage VC is the voltage difference of the supply voltage VDD and the first voltage V1 and the supply voltage VDD is fixed, the capacitor voltage VC varies in response to the first voltage V1.

At time t2, the voltage clamp unit 120 is turned ON, so that the first voltage V1 and the control signal SC are clamped by the turn-on voltage VTO of the voltage clamp unit 120. The resistor current IR keeps in VC/R and the capacitor current IC is zero, while the capacitor voltage VC is the supply voltage VDD minus the turn-on voltage VTO.

At time t3, the first switch S1 is turned OFF and the second switch S2 is turned ON. The resistor current IR, the first voltage V1 at the first node N1, the control signal SC, and the capacitor voltage VC are repeated.

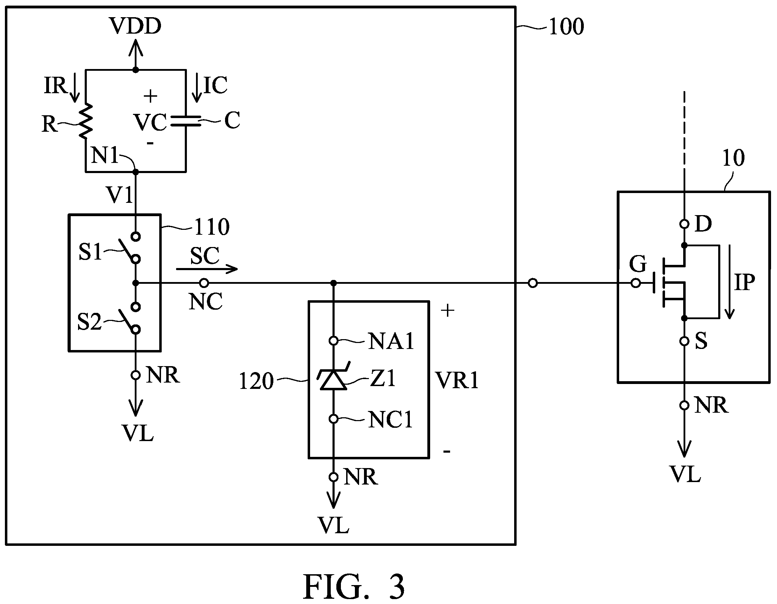

Fig. 3 is a schematic diagram of a gate-driving circuit in accordance with another embodiment of the invention. As shown in Fig. 3, the voltage clamp unit 120 includes a first zener diode Z1. The first zener diode Z1 includes the first anode NA1 and the first cathode NC1. When a current flows through the first zener diode Z1 from the first anode NA1 to the first cathode NC1, the voltage across the first zener diode Z1 is defined as the first reverse breakdown voltage VR1.

According to an embodiment of the invention, when the controller 110 generates the control signal SC in the high voltage level, the control signal SC is eventually clamped at the first reverse breakdown voltage VR1 of the first zener diode Z1. Namely, the first reverse breakdown voltage VR1 is the turn-on voltage VTO in Figs. 1 and 2.

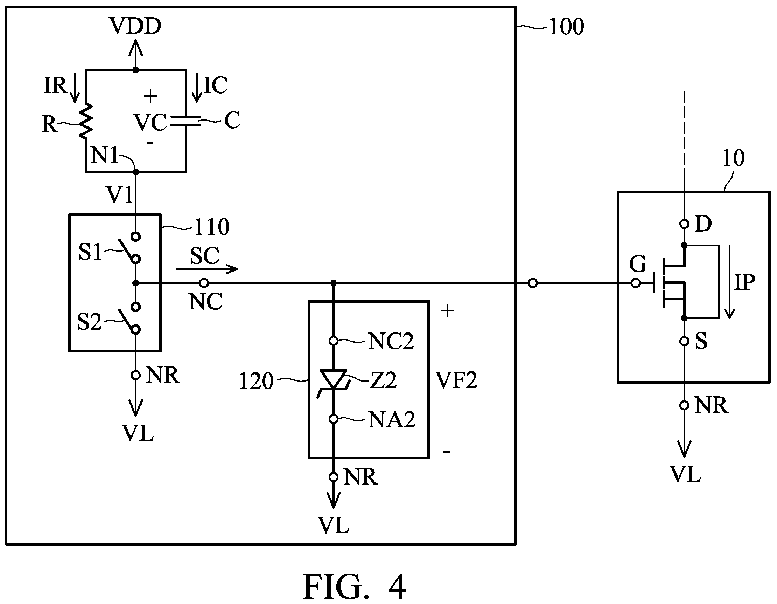

Fig. 4 is a schematic diagram of a gate-driving circuit in accordance with another embodiment of the invention. Comparing the voltage clamp unit 120 in Fig. 4 with that in Fig. 3, the second anode NA2 of the second zener diode Z2 is coupled to the low voltage level VL and the second cathode NC2 of the second zener diode Z2 is coupled to the control node NC.

According to an embodiment of the invention, the controller 110 generates the control signal SC in the high voltage level, the first voltage V1 and the high voltage level of the control signal SC is determined by the second forward voltage VF2 of the second zener diode Z2. Namely, the second forward voltage VF2 is the turn-on voltage VTO in Figs. 1 and 2.

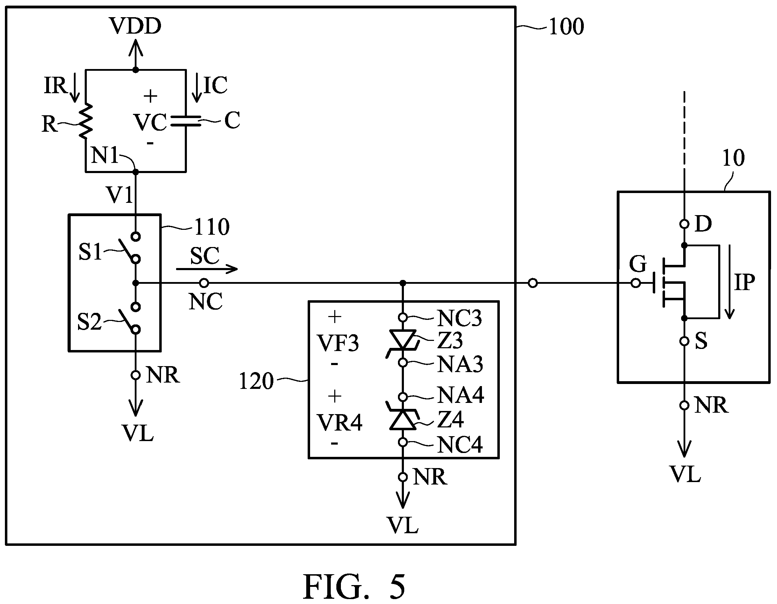

Fig. 5 is a schematic diagram of a gate-driving circuit in accordance with another embodiment of the invention. As shown in Fig. 5, the voltage clamp unit 120 includes the third zener diode Z3 and the fourth zener diode Z4. The third anode NA3 of the third zener diode Z3 is coupled to the fourth anode NA4 of the fourth zener diode Z4. The third cathode NC3 is coupled to the gate terminal G of the switch device 10, and the fourth cathode NC4 is coupled to the source terminal S of the switch device 10.

According to an embodiment of the invention, when the controller 110 generates the control signal SC in the high voltage level, the first voltage V1 and the high voltage level of the control signal SC is clamped at the sum of the third forward voltage VF3 of the third zener diode Z3 and the fourth reverse breakdown voltage VR4 of the fourth zener diode Z4. Namely, the sum of the third forward voltage VF3 of the third zener diode Z3 and the fourth reverse breakdown voltage VR4 of the fourth zener diode Z4 is the turn-on voltage VTO in Figs. 1 and 2.

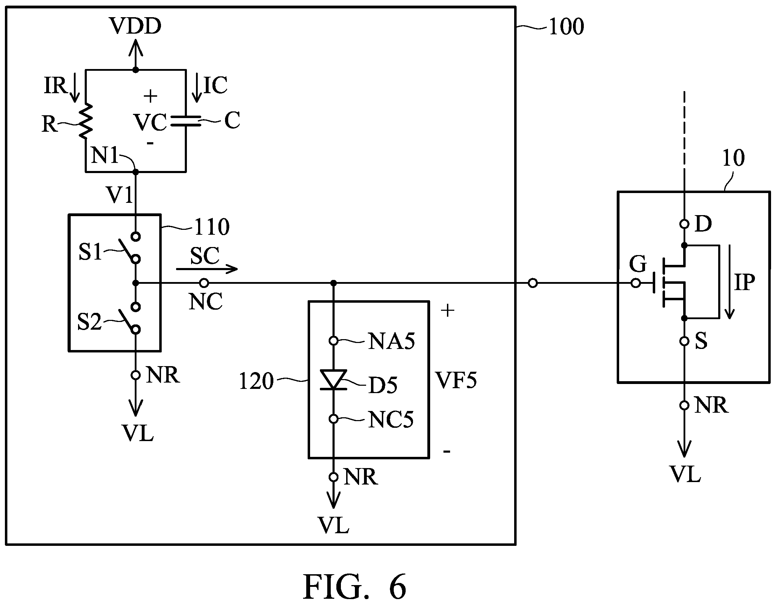

Fig. 6 is a schematic diagram of a gate-driving circuit in accordance with another embodiment of the invention. As shown in Fig. 6, the voltage clamp unit 120 includes the fifth diode D5 which has the fifth forward voltage VF5. According to an embodiment of the invention, when the controller 110 generates the control signal SC in the high voltage level, the first voltage V1 and the high voltage level of the control signal SC is determined by the fifth forward voltage VF5 of the fifth diode D5. Namely, the fifth forward voltage VF5 of the fifth diode D5 is the turn-on voltage VTO in Figs. 1 and 2.

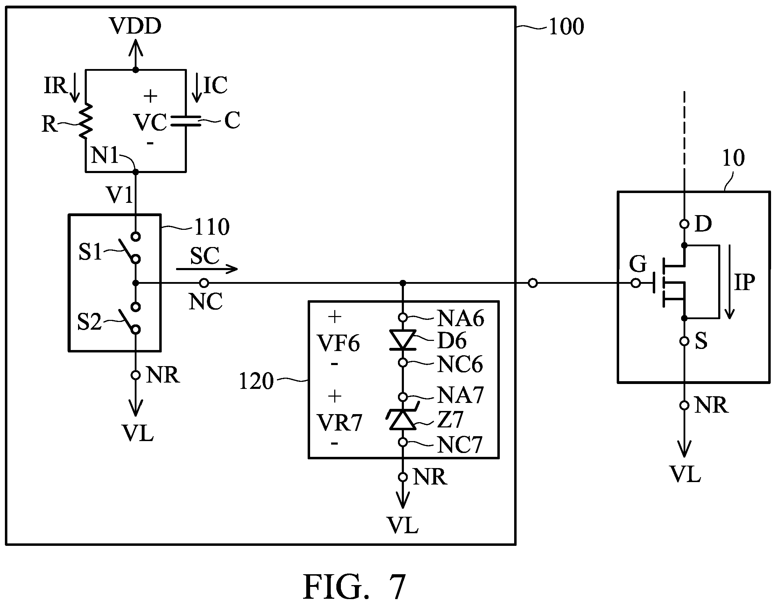

Fig. 7 is a schematic diagram of a gate-driving circuit in accordance with another embodiment of the invention. As shown in Fig. 7, the voltage clamp unit 120 includes the sixth diode D6, which has the sixth forward voltage VF6, and the seventh zener diode Z7, which has the seventh reverse breakdown voltage VR7. The sixth anode NA6 of the sixth diode D6 is coupled to control node NC, and the sixth cathode NC6 is coupled to the seventh anode NA7 of the ninth zener diode Z9. The seventh cathode NC7 is coupled to the source terminal S of the switch device 10.

According to an embodiment of the invention, when the controller 110 generates the control signal SC in the high voltage level, the first voltage V1 and the high voltage level of the control signal SC are clamped at a clamped voltage equal to the sum of the sixth forward voltage VF6 of the sixth diode D6 and the seventh reverse breakdown voltage VR7 of the seventh zener diode Z7. Namely, the sum of the sixth forward voltage VF6 of the sixth diode D6 and the seventh reverse breakdown voltage VR7 of the seventh zener diode Z7 is the turn-on voltage VTO in Figs. 1 and 2.

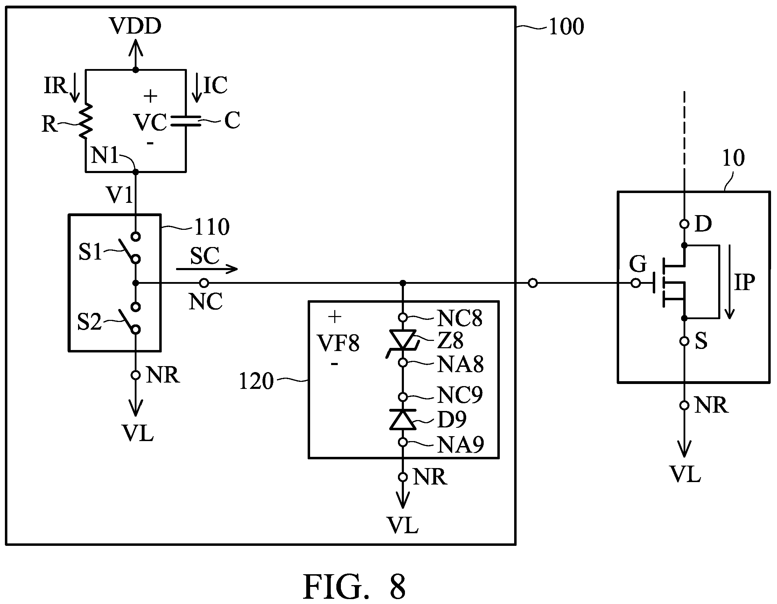

Fig. 8 is a schematic diagram of a gate-driving circuit in accordance with another embodiment of the invention. As shown in Fig. 8, the voltage clamp unit 120 includes the eighth zener diode Z8 and the ninth diode D9. The eighth anode NA8 of the eighth zener diode Z8 is coupled to the ninth cathode NC9 of the ninth diode D9. The eighth cathode NC8 is coupled to the gate terminal G of the switch device 10, and the ninth anode NA9 of the eighth zener diode Z8 of the ninth diode D9 is coupled to the source terminal S of the switch device 10.

According to an embodiment of the invention, when the controller 110 generates the control signal SC in the high voltage level, the first voltage V1 and the high voltage level of the control signal SC can be as high as the supply voltage VDD, since the ninth diode is open when the control signal SC is in the high voltage level.

As illustrated in Figs. 3-14, several embodiments of the gate-driving circuit have been described in detail. A controller, which was designed to drive a Si MOSFET, is able to drive a normally-off GaN FET by inserting the resistor, the capacitor, and the voltage clamp unit illustrated in Figs. 3-8 without modifying the controller, even though the breakdown voltage of a normally-off GaN FET is less than that of a Si MOSFET.

Although some embodiments of the present disclosure and their advantages have been described in detail, it should be understood that various changes, substitutions and alterations can be made herein without departing from the spirit and scope of the disclosure as defined by the appended claims. For example, it will be readily understood by those skilled in the art that many of the features, functions, processes, and materials described herein may be varied while remaining within the scope of the present disclosure. Moreover, the scope of the present application is not intended to be limited to the particular embodiments of the process, machine, manufacture, composition of matter, means, methods and steps described in the specification. As one of ordinary skill in the art will readily appreciate from the disclosure of the present disclosure, processes, machines, manufacture, compositions of matter, means, methods, or steps, presently existing or later to be developed, that perform substantially the same function or achieve substantially the same result as the corresponding embodiments described herein may be utilized according to the present disclosure. Accordingly, the appended claims are intended to include within their scope such processes, machines, manufacture, compositions of matter, means, methods, or steps.

## Claims

1. A circuit comprising:
a resistor, coupled between a supply voltage and a first node;
a capacitor, coupled between the supply voltage and the first node;
a controller, periodically coupling the first node and a reference node to a control node to generate a control signal at the control node, wherein a range of the control signal is from a first voltage of the first node to a low voltage level of the reference node; and
a voltage clamp unit, coupled between the control node and the reference node and determining the first voltage.

2. The circuit of claim 1, wherein the controller comprises:
a first switch, coupling the first node to the control node; and
a second switch, coupling the reference node to the control node, wherein the first switch and the second switch are alternately turned on and off.

3. A gate-driving circuit for turning on and off a switch device (10) having a gate terminal (G) coupled to a control node (NC), a drain terminal (D) sinking a power current (IP), and a source terminal (S) coupled to a reference node (NR), the gate-driving circuit comprising:
a resistor (R), coupled between a supply voltage (VDD) and a first node (N1);
a capacitor (C), coupled between the supply voltage and the first node;
a controller (110), periodically coupling the first node and the reference node to the control node to generate a control signal (SC) at the control node, wherein a range of the control signal is from a first voltage (VI) of the first node to the low voltage level of the reference node; and
a voltage clamp unit (120), coupled between the control node and the reference node and determining the first voltage.

4. The gate-driving circuit of claim 3, wherein the first voltage is not greater than the supply voltage.

5. The gate-driving circuit of claim 3, wherein the controller comprises:
a first switch, coupling the first node to the control node; and
a second switch, coupling the reference node to the control node, wherein the first switch and the second switch are alternately turned on and off.

6. The gate-driving circuit of claim 5, wherein the resistor and the capacitor are configured to determine an overshoot voltage of the control signal in response to the first switch being on, wherein the overshoot voltage is configured to turn on the switch device at high speed.

7. The gate-driving circuit of claim 5, wherein when the first switch is turned on, the supply voltage charges a parasitic capacitor at the control node, wherein once a control voltage of the control node reaches the first voltage, the supply voltage provides a fixed current flowing through the resistor to the voltage clamp unit so that the voltage clamp unit clamps the control signal at a turn-on voltage of the voltage clamp unit.

8. The gate-driving circuit of claim 5, wherein once the first switch is turned off and the second switch is turned on, the supply voltage charges the first node through the resistor, and the control signal is in the low voltage level.

9. The gate-driving circuit of claim 3, wherein the controller, the voltage clamp unit, and the switch device are packaged together.

10. The gate-driving circuit of claim 3, wherein the voltage clamp unit comprises:
a zener diode, comprising an anode and a cathode, wherein the anode is coupled to the source terminal of the switch device, and the cathode is coupled to the gate terminal of the switch device, wherein the first voltage is determined by a reverse breakdown voltage of the zener diode.

11. The gate-driving circuit of claim 3, wherein the voltage clamp unit comprises:
a zener diode, comprising an anode and a cathode, wherein the anode is coupled to the gate terminal of the switch device, and the cathode is coupled to the source terminal of the switch device, wherein the first voltage is determined by a forward voltage of the zener diode.

12. The gate-driving circuit of claim 3, wherein the voltage clamp unit comprises:
a diode, comprising an anode and a cathode, wherein the anode is coupled to the gate terminal of the switch device, and the cathode is coupled to the source terminal of the switch device, wherein the first voltage is determined by a forward voltage of the diode.

13. The gate-driving circuit of claim 3, wherein the voltage clamp unit comprises:
a first zener diode, comprising a first anode and a first cathode, wherein the first anode is coupled to a first node, and the first cathode is coupled to the gate terminal of the switch device; and
a second zener diode, comprising a second anode and a second cathode, wherein the second anode is coupled to the first anode, and the second cathode is coupled to the source terminal of the switch device;
wherein the first voltage is determined by a sum of a reverse breakdown voltage of the second zener diode and a forward voltage of the first zener diode.

14. The gate-driving circuit of claim 3, wherein the voltage clamp unit comprises:
a first diode, comprising a first anode and a first cathode, wherein the first anode is coupled to the gate terminal of the switch device; and
a zener diode, comprising a zener anode and a zener cathode, wherein the zener cathode is coupled to the source terminal of the switch device, and the zener anode is coupled to the first cathode;
wherein the first voltage is determined by a sum of a reverse breakdown voltage of the zener diode and a forward voltage of the diode.

15. The gate-driving circuit of claim 3, wherein the voltage clamp unit comprises:
a zener diode, comprising a zener anode and a zener cathode, wherein the zener cathode is coupled to the gate terminal of the switch device; and
a first diode, comprising a first anode and a first cathode, wherein the first anode is coupled to the source terminal of the switch device, and the first cathode is coupled to the zener anode;
wherein the first voltage is the supply voltage.
